# EUROPEAN PATENT SPECIFICATION

(11) **EP 4 394 415 B1**
(45) Date of publication and mention of the grant of the patent: **09.04.2025**
(21) Application number: 23150058.8
(22) Date of filing: 02.01.2023
(51) Int. Cl.: G01R 31/69

(54) **STAND-ALONE SMART TEST MODULE FOR WIRE HARNESS TESTING SYSTEMS**
EIGENSTÄNDIGES INTELLIGENTES TESTMODUL FÜR KABELBAUMTESTSYSTEME
MODULE DE TEST INTELLIGENT AUTONOME POUR SYSTÈMES DE TEST DE FAISCEAU DE CÂBLES

(43) Date of publication of application: 03.07.2024
(73) Proprietor: Fouad, Hisham, 12566 Six of October City Giza (EG)
(72) Inventor: Fouad, Hisham, 12566 Six of October City Giza (EG)
(74) Representative: MERH-IP Matias Erny Reichl Hoffmann Patentanwälte PartG mbB

(56) References cited:
- CN-A- 114 690 072
- GB-A- 2 170 962
- US-A1- 2009 134 888

## Description

### BACKGROUND

### Field of the Invention:

- The present invention relates to wire harness testing systems, and more particularly to test modules used in testing wiring harnesses

### Description of the Related Art:

- A wire harness is an assembly of electrical cables which is used in automobiles to connect electronic components, control units, sensors and actuators. The single group of wires which transmit signals and electrical power are bundled by straps, cable ties, cable ducts, adhesive tape and the like. The cable ends are fitted with electrical terminals, optionally equipped with wire seals and inserted in electrical connectors, plugs (male-ended) and jacks (female-ended).
- A wire harness is usually designed in accordance to electrical, geometrical and environmental requirements. Testing the continuity of the wire harness is done using test modules, these test modules include test probes which are incorporated into a designed housing structure that acts as the mating connector and will be keyed to only accept the connector in the proper mating orientation. The material that is used in the test fixture housing is generally some type of non-conductive plastic or wood.
- The testing process is usually carried out separately on a testing machine, but in some cases it can be integrated on the assembly board. Test on assembly process especially for high volume wire harnesses requires producing multiples of the same assembly board for a certain wire harness model, which has a tangible impact on the project cost.
- Normally each model of wire harnesses needs a separate test machine, each wire harness comes with different connectors which require new designs and manufacturing of new housing structures, which act as mating for these different connectors. This process is time consuming and relatively high cost if compared to other techniques like the present invention discloses.
- Currently test machines for wiring harnesses consist of test hardware boards, test modules and test software, the software is driving the test hardware boards while the test modules are driven by the hardware boards.

CN 114 690 072 A, GB 2 170 962 A and US 2009/134888 A1 disclose wire harness test modules comprising printed circuit boards and cylindrical vertical probes.

### SUMMARY

The invention is defined by claim 1.
- In the present invention the hardware boards and the test modules are integrated so that each module is a self-driven stand-alone test machine that has the ability to communicate with other test modules through network to act as a wiring harness test machine using the software that manages the communication.
- In one embodiment of the present invention, smart test module is designed and manufactured using PCB (printed circuit board) technology, smart test module is comprised of three PCBs, but in minor cases it may require to add extra boards to achieve complicated 3D connectors structures. These three PCBs are arranged vertically to achieve the 3D shape of the traditional test module housing structure which is manufactured using CNC machines. Two layer printed circuit boards are lower cost and have significantly shorter lead time compared to milling and drilling CNC machine, especially in such application of manufacturing 3D housing structures of wire harness connectors. For high-volume projects it needs multiples of test machines to reduce production lead time; therefor multiple clones of the same test module need to be produced. This is also the case when it comes to test on assembly. By involving the PCB technology in producing the test module as disclosed in the present invention it helps to significantly reduce the total cost and production lead time of high volume wire harnesses projects particularly; as producing copies of the same printed circuit board almost adds a slight intangible cost in contrast to reproducing the same test module structure by CNC machine.
- In another embodiment of the present invention, smart test module comprises of test probe pins which are soldered in two vertical PCBs, adding more robustness, reliability and durability to test modules, avoiding soldering the wires directly to the test probes. By soldering the test probes directly to the boards it ensures the required arrangement of test probe pins inside the test module as well.
- An additional embodiment of the present invention, another printed circuit board fixed at the bottom of the smart test module is part of it. This board is the brain of the module which includes a microcontroller that is connected wirelessly or through standard local network to the PC which runs the software of the test machine. The board is connected to the test probes above it directly using ready manufactured short cables which replace the long cables used in the traditional test module. In this case it is no longer needed to solder the wires to the test probes. The test probes are soldered on the higher board and electrically conveyed to the edge of the board by the copper traces of the printed circuit board and downwards to the microcontroller board through short cables, which reduces the overall cost of the test machine; therefore the need of a large test machine station is no longer there, which hugely impacts the cost of such test module

### BRIEF DESCRIPTION OF THE DRAWINGS

[Fig. 1] Smart test module structure

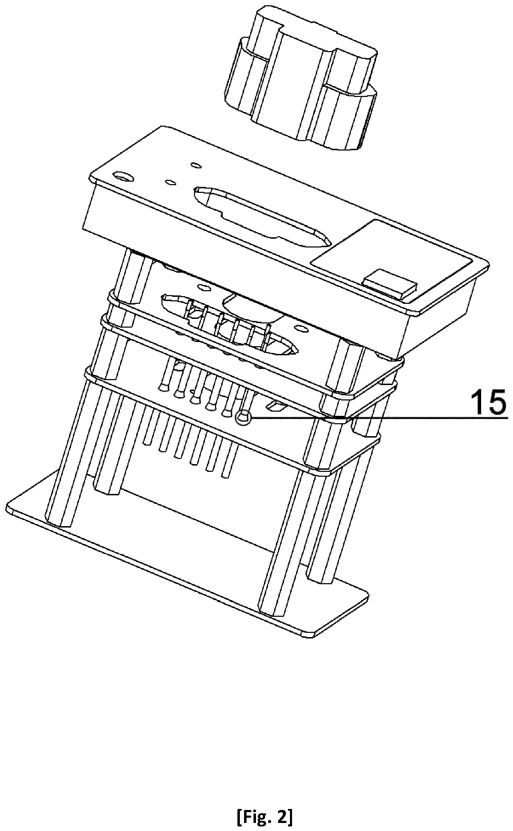

[Fig. 2] Smart test module with a connector, it shows Standard PCB soldering joint (15)

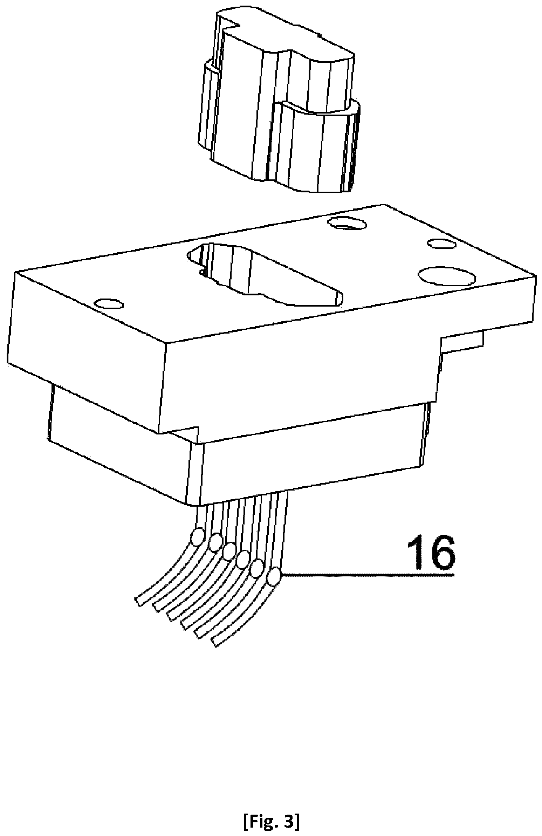

[Fig. 3] Traditional test module, it shows current connection between test module and test machine (always using a very poor soldering process) (16)

### DETAILED DESCRIPTION

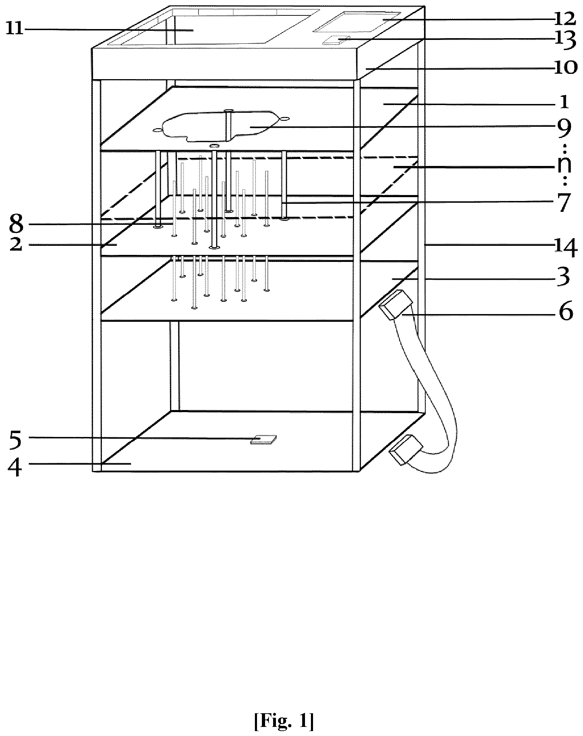

- The present invention relates to wire harness test modules, as disclosed in [Fig. 1], smart test module comprises of at least three printed circuit boards (PCBs) (1), (2), (3) arranged from top to bottom respectively, (n) refers to additional number of boards that may be needed according to the complexity of the geometry of the desired connector to be tested, these three printed circuit boards are the main part of the smart test module, each board has a certain function and all of them combined with the solid cylindrical shafts (7) are emulating the 3D shape of the connector, previously the 3D shape was milled inside a non-conductive material using CNC machine, the 2D shape of the outer contour of the connector (9) is cut out inside the first board (1) which enables the connector to pass through this board and this is the main function of the first board, then to guide the connector vertically downwards till it touches and makes a contact with the test probes (8) vertical long solid cylindrical shafts (7) are used for that, these solid cylindrical shafts (7) are soldered on the third board (3) and passing through the second board (2), they are made longer enough to touch the bottom surface of the first board (1), the solid cylindrical shafts (7) are distributed vertically around the contour (9) that has been cut out inside the first board (1), the 2 boards (2) and (3) are identical, this means they have the same design for each connector, the main function of the second board (2) is supporting the test probes (8) and the solid cylindrical shafts (7), so both of the test probes (8) and solid cylindrical shafts (7) are soldered on the third board (3) and passing through the second board (2), in order to electrically sense the test probes (8) their electrical signals are transferred by the third board (3) copper traces to the edge of this board then by the use of ready manufactured short cables (6) the signals are transferred downwards to the fourth board (4) which has the microcontroller (5), the fourth board (4) is the smart part of the test module it is connected wirelessly or through standard local network to the PC which has the software running on it, by integrating the microcontroller unit on the fourth board (4) into the smart test module it makes it performs as a standalone wire harness testing device, therefor the smart test module can be considered as a building block unit for testing wire harness systems whether in test machines or on assembly boards where test on assembly is carried on, the new technique achieved by applying PCB technology in the core structure of the wire harness test modules will help in reducing lead time of producing wire harness test machines, it also significantly reduces the total cost of the test machine as well as increasing the robustness, durability and reliability of such test modules Normally changes are applied on the wire harness and new models of the same vehicle are produced; this requires changes in the test machine, some test modules become obsolete, with the new structure of the smart test module it only requires replacing the middle part of the module with another 3 boards which two of them are identical, making test module reusable.

As disclosed in FIG. 1 smart test module comprises of OLED display (12) which is an interface to view some useful information to the worker who carries on the testing process of the wire harness on the test machine, the OLED display shows the position of the wire that has an error like being switched with another wire, or being missed from its correct position(an open circuit), or being shorted with another wire(a short circuit), all these kinds of errors are common mistakes that could happen during the manual assembly process of the wire harness, detecting those kinds of errors during continuity test is the main function for wire harness test machines to perform, by displaying related and relevant information of the connector wires and terminals on the test module itself it becomes easier and time-saving for the worker besides viewing all errors of the whole harness on the PC screen, smart test module comprises of push button with led indicator (13) this is used normally for getting the connector out of the test module after performing the test or getting it out for fixing an error after being detected, it is not just the case for smart test module, this button is multifunction according to the mode of the operation, it is used for switching between errors displayed on the OLED display (12), switching between instructions displayed on the OLED display (12) and for confirming by long press some steps while testing process, the OLED display and the push button are together fixed on the top of test module on a frame that is made of plastic or any other non-conductive material (10) this frame in contrast to traditional test modules is one time design and independent of the connectors different shapes and designs, it has a standard size opening (11) that provides an easy pass through for the majority of connectors used in wire harnesses.

## Claims

1. A wire harness stand-alone smart test module,
comprising:
a top non-conductive frame (10); an OLED display (12) and a push button (13) both attached to the top non-conductive frame;
at least three printed circuit boards (1), (2), (3) arranged vertically from top to bottom respectively below the said top non-conductive frame;
a plurality of long solid cylindrical shafts (7) distributed vertically below the first board (1) and soldered on the second board (2), or passing through extra boards if exist according to the geometry of the connector to be tested;
a plurality of test probes (8) attached vertically, passing through the second board (2) and soldered on both the second (2) and the third (3) printed circuit boards;
a bottom printed circuit board (4) with a microcontroller (5) connected to the third printed circuit board (3) with at least one short customized cable;
a set of at least four shafts (14) to hold the said frame and the said four printed circuit boards all together.

2. A wire harness stand-alone smart test module according to claim 1, wherein the fourth printed circuit board (4) are used to connect the smart test module wirelessly or through standard local network to the PC which is running the testing software of the wire harness.

3. A wire harness stand-alone smart test module according to claim 2 is considered a building block for wire harness testing systems, introducing the concept of a modular test machine without the need of a centralized hardware circuit to control the functionality of the test machine.

4. A wire harness stand-alone smart test module according to claim 1, wherein the non-conductive frame has an opening (11) for the wire harness connector to pass through.

5. A wire harness stand-alone smart test module according to claim 1, wherein the first printed circuit board (1) has a cutout inside (9), which its perimeter matches the outer contour of a desired connector of the wire harness.

6. A wire harness stand-alone smart test module according to claim 1, wherein the second printed circuit board (2) is used for holding the test probes (8) and the long solid cylindrical shafts (7).

7. A wire harness stand-alone smart test module according to claim 1, wherein the third printed circuit board (3) is used for transferring the electrical signals of the said test probes to the said bottom microcontroller printed circuit board (4) through the said short customized cable.

8. A wire harness stand-alone smart test module according to claim 1, wherein the OLED display (12) and the push button (13) are used respectively to view useful data of the connector to be tested and choose between features viewed on the OLED display.

## Patentansprüche

1. Eigenständiges intelligentes Testmodul für einen Kabelbaum,
umfassend:
einen oberen nichtleitenden Rahmen (10); eine OLED-Anzeige (12) und einen Druckknopf (13), die beide an dem oberen nichtleitenden Rahmen angebracht sind;
mindestens drei Leiterplatten (1), (2), (3), die vertikal von oben nach unten jeweils unter dem oberen nichtleitenden Rahmen angeordnet sind;
eine Vielzahl von langen massiven zylindrischen Wellen (7), die vertikal unter der ersten Platte (1) verteilt und auf die zweite Platte (2) gelötet sind oder durch zusätzliche Platten verlaufen, wenn sie gemäß der Geometrie des zu testenden Verbinders vorhanden sind;
eine Vielzahl von Testsonden (8), die vertikal angebracht sind, durch die zweite Platte (2) verlaufen und sowohl auf die zweite (2) als auch die dritte (3) Leiterplatte gelötet sind;
eine untere Leiterplatte (4) mit einem Mikrocontroller (5), der mit der dritten Leiterplatte (3) mit mindestens einem kurzen kundenspezifischen Kabel verbunden ist;
einen Satz von mindestens vier Wellen (14), um den Rahmen und die vier Leiterplatten alle zusammen zu halten.

2. Eigenständiges intelligentes Testmodul für einen Kabelbaum nach Anspruch 1, wobei die vierte Leiterplatte (4) verwendet wird, um das intelligente Testmodul drahtlos oder durch ein lokales Standardnetzwerk mit dem PC zu verbinden, der die Testsoftware des Kabelbaums ausführt.

3. Eigenständiges intelligentes Testmodul für einen Kabelbaum nach Anspruch 2, das als ein Baustein für Kabelbaum-Testsysteme betrachtet wird, wobei das Konzept einer modularen Testmaschine eingeführt wird, ohne dass eine zentralisierte Hardwareschaltung erforderlich ist, um die Funktionalität der Testmaschine zu steuern.

4. Eigenständiges intelligentes Testmodul für einen Kabelbaum nach Anspruch 1, wobei der nichtleitende Rahmen eine Öffnung (11) aufweist, durch die der Kabelbaum-Verbinder hindurchgehen kann.

5. Eigenständiges intelligentes Testmodul für einen Kabelbaum nach Anspruch 1, wobei die erste Leiterplatte (1) eine ausgeschnittene Innenseite (9) aufweist, deren Umfang mit der Außenkontur eines gewünschten Verbinders des Kabelbaums übereinstimmt.

6. Eigenständiges intelligentes Testmodul für einen Kabelbaum nach Anspruch 1, wobei die zweite Leiterplatte (2) zum Halten der Testsonden (8) und der langen massiven zylindrischen Wellen (7) verwendet wird.

7. Eigenständiges intelligentes Testmodul für einen Kabelbaum nach Anspruch 1, wobei die dritte Leiterplatte (3) zum Übertragen der elektrischen Signale der Testsonden zu der unteren Mikrocontroller-Leiterplatte (4) durch das kurze kundenspezifische Kabel verwendet wird.

8. Eigenständiges intelligentes Testmodul für einen Kabelbaum nach Anspruch 1, wobei die OLED-Anzeige (12) und der Druckknopf (13) jeweils verwendet werden, um nützliche Daten des zu testenden Verbinders zu betrachten und zwischen Merkmalen zu wählen, die auf der OLED-Anzeige betrachtet werden.

## Revendications

1. Module de test intelligent autonome de faisceau de câbles,
comprenant:
un cadre non conducteur supérieur (10) ; un affichage OLED (12) et un bouton-poussoir (13) tous deux fixés au cadre non conducteur supérieur;
au moins trois cartes de circuit imprimé (1), (2), (3) agencées verticalement de haut en bas respectivement en dessous dudit cadre non conducteur supérieur;
une pluralité de longs arbres cylindriques pleins (7) distribués verticalement en dessous de la première carte (1) et soudés sur la deuxième carte (2), ou passant à travers des cartes supplémentaires si elles existent selon la géométrie du connecteur à tester;
une pluralité de sondes de test (8) fixées verticalement, passant à travers la deuxième carte (2) et soudées à la fois sur la deuxième (2) et la troisième (3) carte de circuit imprimé;
une carte de circuit imprimé inférieure (4) avec un microcontrôleur (5) connecté à la troisième carte de circuit imprimé (3) avec au moins un câble court personnalisé;
un ensemble d'au moins quatre arbres (14) pour maintenir ledit cadre et lesdites quatre cartes de circuit imprimé tous ensemble.

2. Module de test intelligent autonome de faisceau de câbles selon la revendication 1, dans lequel la quatrième carte de circuit imprimé (4) est utilisée pour connecter le module de test intelligent sans fil ou par l'intermédiaire d'un réseau local standard au PC qui exécute le logiciel de test du faisceau de câbles.

3. Module de test intelligent autonome de faisceau de câbles selon la revendication 2 est considéré comme un bloc de construction pour des systèmes de test de faisceau de câbles, introduisant le concept d'une machine de test modulaire sans la nécessité d'un circuit matériel centralisé pour commander la fonctionnalité de la machine de test.

4. Module de test intelligent autonome de faisceau de câbles selon la revendication 1, dans lequel le cadre non conducteur a une ouverture (11) pour que le connecteur de faisceau de câbles passe à travers.

5. Module de test intelligent autonome de faisceau de câbles selon la revendication 1, dans lequel la première carte de circuit imprimé (1) a une découpe intérieure (9), dont le périmètre correspond au contour extérieur d'un connecteur souhaité du faisceau de câbles.

6. Module de test intelligent autonome de faisceau de câbles selon la revendication 1, dans lequel la deuxième carte de circuit imprimé (2) est utilisée pour maintenir les sondes de test (8) et les longs arbres cylindriques pleins (7).

7. Module de test intelligent autonome de faisceau de câbles selon la revendication 1, dans lequel la troisième carte de circuit imprimé (3) est utilisée pour transférer les signaux électriques desdites sondes de test à ladite carte de circuit imprimé de microcontrôleur inférieure (4) par l'intermédiaire dudit câble court personnalisé.

8. Module de test intelligent autonome de faisceau de câbles selon la revendication 1, dans lequel l'affichage OLED (12) et le bouton-poussoir (13) sont utilisés respectivement pour visualiser des données utiles du connecteur à tester et choisir entre des caractéristiques visualisées sur l'affichage OLED.
